# EUROPÄISCHE PATENTSCHRIFT

(11) **EP 2 483 928 B1**
(45) Veröffentlichungstag und Bekanntmachung des Hinweises auf die Patenterteilung: **24.01.2018**
(21) Anmeldenummer: 10760668.3
(22) Anmeldetag: 28.09.2010
(51) Int. Cl.: H01L 29/74, H01L 29/06, H01L 31/111, H01L 29/10

(54) **ZÜNDSTUFENTHYRISTOR MIT ENTKOPPELTER ZÜNDSTUFE**
TRIGGER STAGE THYRISTOR HAVING DECOUPLED TRIGGER STAGE
THYRISTOR À ÉTAGE D'AMORÇAGE COMPRENANT UN ÉTAGE D'AMORÇAGE DÉCOUPLÉ

(30) Priorität: 30.09.2009 DE 102009045178
(43) Veröffentlichungstag der Anmeldung: 08.08.2012
(73) Patentinhaber: Infineon Technologies Bipolar GmbH & Co. KG, 59581 Warstein (DE)
(72) Erfinder: KELLNER-WERDEHAUSEN, Uwe, 91359 Leutenbach (DE); SILBER, Dieter, 63179 Obertshausen (DE); CHUKALURI, Eswar Kumar, ST16 3PG Stafford (GB)
(74) Vertreter: Lohmanns, Bernard
(86) Internationale Anmeldenummer: PCT/EP2010/064374
(87) Internationale Veröffentlichungsnummer: WO 2011/039193

(56) Entgegenhaltungen:
- EP-A2- 0 669 659
- DE-T2- 69 426 319
- JP-A- S5 681 970
- US-A1- 2009 057 714

## Beschreibung

Die Erfindung betrifft Zündstufenthyristoren. Bei Thyristoren besteht das Problem, dass sie zerstört werden können, wenn während der Sperrverzögerungszeit (engl.: reverse recovery time), in der an der Kathode ein gegenüber der Anode positives elektrisches Potenzial anliegt, ein steiler Spannungsanstieg in Durchlassrichtung auftritt.

Die Aufgabe der vorliegenden Erfindung besteht darin, einen Zündstufenthyristor bereitzustellen, der im Falle steiler, während der Sperrverzögerungszeit auftretende Spannungspulse besser geschützt ist.

Diese Aufgaben werden durch einen Thyristor gemäß Patentanspruch 1 gelöst. Ausgestaltungen und Weiterbildungen der Erfindung sind Gegenstand von Unteransprüchen.

Im Unterschied zu herkömmlichen Zündstufenthyristoren, bei denen entsprechende erste und zweite Kontaktflächen unmittelbar aneinander grenzen und dadurch eine zusammenhängende Fläche ausbilden, innerhalb der an der Vorderseite der pn-Übergang zwischen der p-dotierten Basis und der dem n-dotierten Hauptemitter zugewandten Seite des betreffenden n-dotierten Zündstufenemitters verläuft, ist bei einem Thyristor gemäß der vorliegenden Erfindung bei zumindest einem der n-dotierten Zündstufenemitter die zweite Kontaktfläche von diesem n-dotierten Zündstufenemitter beabstandet. Anders ausgedrückt bedeutet das, dass sich bei zumindest einem der n-dotierten Zündstufenemitter die Kontaktfläche zwischen diesem n-dotierten Zündstufenemitter und der p-dotierten Basis auf der dem n-dotierten Hauptemitter zugewandten Seite des n-dotierten Zündstufenemitters befindet und von diesem beabstandet ist.

Hierdurch entsteht die Möglichkeit, die Netto-Dotierstoffkonzentration der p-dotierten Basis im Vergleich zu einem herkömmlichen Thyristor im Bereich des betreffenden n-dotierten Zündstufenemitters lokal anzuheben, was eine Erhöhung des Verstärkungsfaktors βₚₙₚ des unterhalb des betreffenden n-dotierten Zündstufenemitters aus der p-dotierten Basis, der n-dotierten Basis und dem p-dotierten Emitter gebildeten pnp-Transistors bewirkt. Eine solche Erhöhung des Verstärkungsfaktors βₚₙₚ führt während der Sperrverzögerungszeit zu einer Erhöhung der Konzentration des Restplasmas im Bereich der betreffenden Zündstufe. Hierdurch kann erreicht werden, dass der Thyristor gezielt im Bereich dieser Zündstufe zündet, wenn während der Sperrverzögerungszeit ein Spannungspuls in Vorwärtsrichtung auftritt, dessen zeitliche Ableitung einen kritischen Wert übersteigt.

Eine alleinige Erhöhung der Netto-Dotierstoffkonzentration der p-dotierten Basis im Bereich des betreffenden n-dotierten Zündstufenemitters führt jedoch zugleich zu einer lokalen Verringerung des elektrischen Widerstandes der p-dotierten Basis. Damit eine Zündstufe bei einem vorgegebenen Strom zündet, muss je nach Material des Halbleiterkörpers in einer Richtung in etwa senkrecht zur vertikalen Richtung eine gewisse Mindestspannung, beispielsweise 0,7 V bis 0,8 V, über dem Abschnitt der p-dotierten Basis abfallen, der unterhalb des gemeinsamen Gebietes aus dem betreffenden n-dotierten Zündstufenemitter und der betreffenden Elektrode angeordnet ist. Bei einem herkömmlichen Thyristor würde deshalb eine solche im Bereich des betreffenden n-dotierten Zündstufenemitters vorgenommene Erhöhung der Netto-Dotierstoffkonzentration dazu führen, dass die vorgenannte Mindestspannung erst bei einem höheren Strom erreicht wird, was jedoch unerwünscht ist, da hierdurch die Gesamteigenschaften des Thyristors verändert würden.

Indem bei einem Thyristor gemäß der vorliegenden Erfindung die zweite Kontaktfläche von dem zugehörigen n-dotierten Zündstufenemitter beabstandet ist, wird der für das Erreichen der vorgenannten Mindestspannung maßgebliche Bereich der p-dotierten Basis und damit einhergehend der für das Erreichen der Mindestspannung maßgebliche elektrische Widerstand vergrößert, so dass die Erhöhung der Netto-Dotierstoffkonzentration der p-dotierten Basis im Bereich des betreffenden n-dotierten Zündstufenemitters kompensiert werden kann. Dokument DE69426319 T2 offenbart einen Thyristor mit Hilfsemitterelektrode mit erhöhtem Haltestrom.

Dokument US2009057714 A1 offenbart einen Thyristor mit Zündstufenstruktur. Thyristoren mit Emitterelektroden sind auch aus den Dokumenten EP0669659 A2 und JPS5681970 A bekannt. Die Erfindung wird nachfolgend anhand von Ausführungsbeispielen unter Bezugnahme auf Figuren näher erläutert. Es zeigen:
- Figur 1: einen Vertikalschnitt durch einen Thyristor, bei dem die Netto-Dotierstoffkonzentration der p-dotierten Basis im Bereich eines n-dotierten Zündstufenemitters lokal erhöht ist;
- Figur 2: einen vergrößerten Abschnitt des in Figur 1 gezeigten Thyristors;
- Figur 3A: einen Abschnitt des in den Figuren 1 und 2 gezeigten Thyristors im Bereich der zweiten Zündstufe, wobei zusätzlich drei zur vertikalen Richtung senkrecht verlaufende Achsen dargestellt sind, entlang denen der Halbleiterkörper unterschiedliche Verläufe der Netto-Dotierstoffkonzentration aufweist;
- Figur 3B: ein Beispiel für einen Verlauf der Netto-Dotierstoffkonzentration entlang der in Figur 3A gezeigten Achse a1;
- Figur 3C: ein Beispiel für einen Verlauf der Netto-Dotierstoffkonzentration entlang der in Figur 3A gezeigten Achse a2;
- Figur 3D: ein Beispiel für einen Verlauf der Netto-Dotierstoffkonzentration entlang der in Figur 3A gezeigten Achse a3;
- Figur 4A: einen Abschnitt eines Thyristors, der sich von dem in Figur 3A gezeigten Thyristor dadurch unterscheidet, dass die Dicke eines der n-dotierten Zündstufenemitter größer ist als die kleinste Dicke, die die p-dotierte Basis unterhalb der diesen Zündstufenemitter kontaktierenden Zündstufenelektrode aufweist;
- Figur 4B: ein Beispiel für einen Verlauf der Netto-Dotierstoffkonzentration entlang einer in Figur 4A gezeigten Achse a4;
- Figur 5: einen Vertikalschnitt durch einen Abschnitt eines Thyristors, bei dem die Netto-Dotierstoffkonzentration der p-dotierten Basis im Bereich des n-dotierten Zündstufenemitters der ersten Zündstufe lokal erhöht ist;
- Figur 6: einen Vertikalschnitt durch einen Abschnitt eines Thyristors, der den Aufbau des Thyristors gemäß Figur 2 aufweist und der darüber hinaus noch mehrere Entkopplungsstrukturen aufweist, mittels denen Abschnitte der p-dotierten Basis ganz zumindest teilweise elektrisch voneinander entkoppelt sind
- Figur 7: einen Horizontalschnitt durch den in Figur 6 gezeigten Thyristorabschnitt mit mehreren Entkopplungsstrukturen, die jeweils als geschlossene Ringe ausgebildet sind, in einer zur vertikalen Richtung senkrechten Schnittebene E; und
- Figur 8: einen Horizontalschnitt durch den in Figur 6 gezeigten Thyristorabschnitt mit mehreren Entkopplungsstrukturen, von denen jeder eine Vielzahl von Fortsätzen der n-dotierten Basis umfasst, die entlang eines Ringes beabstandet voneinander angeordnet sind, in einer zur vertikalen Richtung senkrechten Schnittebene.

Sofern nicht anders angegeben, bezeichnen in den Figuren gleiche Bezugszeichen gleiche oder äquivalente Elemente mit gleicher oder äquivalenter Funktion. Zur besseren Erkennbarkeit sind die dargestellten Thyristoren und Thyristorabschnitte nicht maßstäblich.

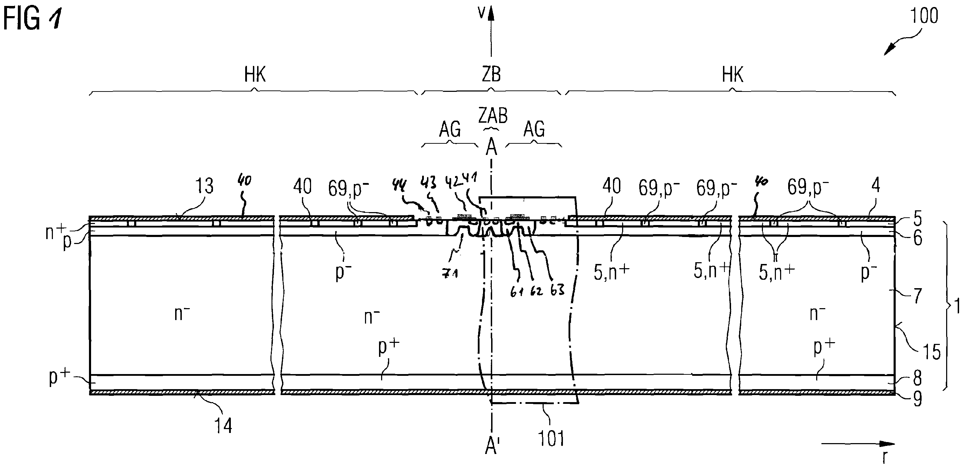

Figur 1 zeigt einen Vertikalschnitt durch einen Thyristor 100. Der Thyristor umfasst einen Halbleiterkörper 1, der im Wesentlichen die Gestalt eines sehr flachen Zylinders aufweist, dessen Grundflächen senkrecht zu einer vertikalen Richtung v verlaufen. Abweichend davon kann der Halbleiterkörper 1 auch eine beliebige andere, von der Zylinderform abweichende Form aufweisen. Jede Richtung senkrecht zur vertikalen Richtung v wird nachfolgend als laterale Richtung bezeichnet, wobei in Figur 1 beispielhaft eine laterale Richtung r dargestellt ist.

Der Halbleiterkörper 1 ist aus einem Halbleitermaterial, z.B. Silizium oder Siliziumcarbid, gebildet und weist p- und n-leitend dotierte Halbleiterzonen auf, welche die elektrischen Eigenschaften des Thyristors 100 festlegen. Der Thyristor 100 und/oder der Halbleiterkörper 1 können optional rotationssymmetrisch bezüglich einer in der vertikalen Richtung v verlaufenden Achse A-A' ausgebildet sein, wobei die Zähligkeit der Achse A-A' grundsätzlich beliebig gewählt werden kann. Beispielsweise kann die Zähligkeit identisch sein mit der Zähligkeit, die die Kristallgitterstruktur des Halbleiterkörpers 1 in Bezug auf dieselbe Achse A-A' aufweist.

Der Thyristor ist asymmetrisch sperrend und umfasst einen Halbleiterkörper 1, in dem in der vertikalen Richtung v ausgehend von einer Rückseite 14 hin zu einer der Rückseite 14 gegenüber liegenden Vorderseite 13 ein p-dotierter Emitter 8, eine n-dotierte Basis 7, eine p-dotierte Basis 6 und ein n-dotierter Emitter 5 aufeinanderfolgend angeordnet sind. Die vertikale Richtung v kann, wie gezeigt, senkrecht zur Rückseite 14 verlaufen.

Auf die Vorderseite 13 des Halbleiterkörpers 1 ist eine strukturierte Metallisierungsschicht 4 mit voneinander beabstandeten Abschnitten 40, 41, 42, 43, 44 aufgebracht. Der Abschnitt 40 ist elektrisch leitend mit dem n-dotierten Emitter 5 verbunden und bildet die Kathodenelektrode des Thyristors 100. Auf die Rückseite 14 ist eine Metallisierungsschicht 9 aufgebracht, die elektrisch leitend mit dem p-dotierten Emitter 8 verbunden ist und die die Anodenelektrode des Thyristors 100 darstellt. Der n-dotierte Emitter 5 ist von säulenartig ausgebildeten, komplementär zum n-dotierten Emitter dotierten Kathodenkurzschlüssen 69 durchsetzt, die die p-dotierte Basis 4 elektrisch an die Kathodenelektrode 4 anschließen.

Der Abschnitt des Thyristors 100, der sich senkrecht zur vertikalen Richtung v über denselben Bereich erstreckt wie der n-dotierte Emitter 5, wird nachfolgend als Hauptkathodenbereich HK bezeichnet. Der Hauptkathodenbereich HK ist bei dem Ausführungsbeispiel gemäß Figur 1 zylinderringförmig ausgebildet und umgibt einen Zündbereich ZB, der einen Zündauslösebereich ZAB aufweist, in dem eine Zündung des Thyristors gezielt ausgelöst werden kann. Hierzu kann der Zündauslösebereich ZAB beispielsweise einen lichtempfindlichen Bereich aufweisen, so dass der Thyristor durch Einstrahlung von Licht in diesen Bereich mit erhöhter Lichtempfindlichkeit gezündet werden kann (LTT = Light Triggered Thyristor). Alternativ oder ergänzend kann der Thyristor auch eine auf die Vorderseite 13 aufgebrachte Gateelektrode (nicht dargestellt) aufweisen, mit der der Thyristor elektrisch gezündet werden kann. Weiterhin umfasst der Zündbereich ZB eine Zündstufenstruktur AG (AG = Amplifying Gate) mit einer oder mehreren Zündstufen.

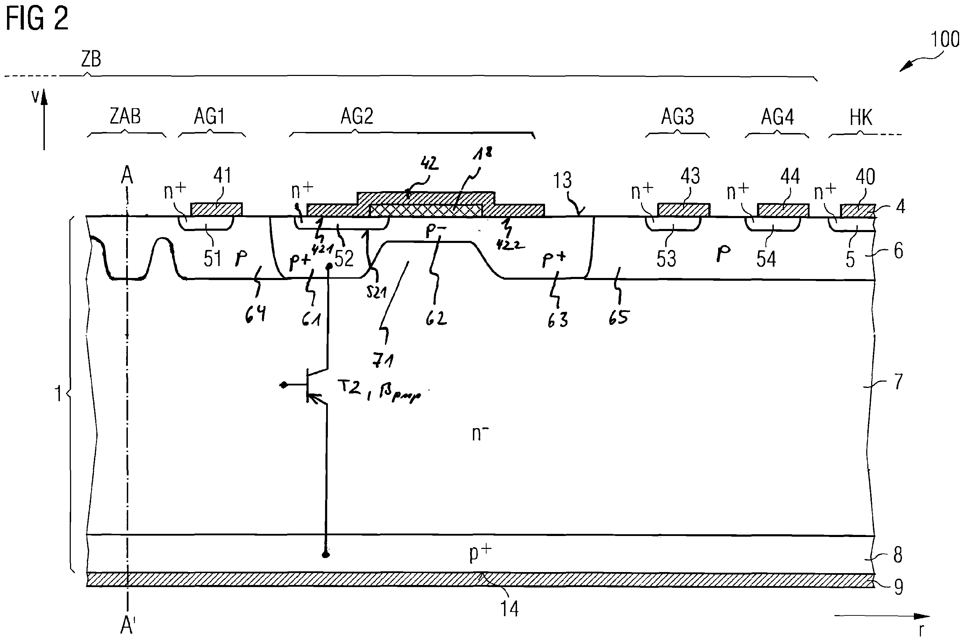

Ein zentraler Abschnitt 101 des Thyristors 100, der den Zündauslösebereich ZAB und die Zündstufenstruktur AG umfasst, ist in Figur 2 vergrößert dargestellt. Der zentrale Abschnitt 101 umfasst beispielhaft vier Zündstufen AG1, AG2, AG3 und AG4, die in lateraler Richtung r aufeinanderfolgend und beabstandet voneinander angeordnet sind. Die Zündstufen AG1, AG2, AG3, AG4 weisen jeweils einen stark n-dotierten Zündstufenemitter 51, 52, 53 bzw. 54 auf. Jeder dieser Zündstufenemitter 51, 52, 53 bzw. 54 ist elektrisch leitend mit einem der Abschnitte 41, 42, 43 bzw. 44 verbunden, der wiederum auf der dem Zündauslösebereich ZAB abgewandten Seite des zugehörigen Zündstufenemitters 51, 52, 53 bzw. 54 elektrisch leitend mit einem Abschnitt der p-dotierten Basis 6 verbunden ist. Dabei überragt jeder der Abschnitte 41, 42, 43, 44 den betreffenden Zündstufenemitter 51, 52, 53 bzw. 54 auf dessen dem Zündauslösebereich ZAB zugewandter Seite. Die Abschnitte 41, 42, 43, 44 werden nachfolgend auch als Zündstufenelektroden 41, 42, 43 bzw. 44 bezeichnet.

Nach der Zündung des Thyristors 100 im Zündauslösebereich ZAB zünden von diesem ausgehend in lateraler Richtung r zeitlich aufeinanderfolgend zuerst die Zündstufe AG1, dann AG2, gefolgt von AG3 und schließlich AG4, bis der Thyristor 100 zuletzt auch im Hauptkathodenbereich HK zündet. Die Zündempfindlichkeit der Zündstufen AG1, AG2, AG3 und AG4 kann dabei ausgehend vom Zündauslösebereich ZAB zum Hauptkathodenbereich HK hin abnehmen.

Die eingangs erläuterte Erhöhung des Verstärkungsfaktors βₚₙₚ eines im Bereich einer Zündstufe angeordneten, aus der p-dotierten Basis 6, der n-dotierten Basis 7 und dem p-dotierten Emitter 8 gebildeten pnp-Transistors ist in Figur 2 beispielhaft anhand der zweiten Zündstufe AG2 erläutert. Entgegen der vertikalen Richtung v in etwa unterhalb des n-dotierten Zündstufenemitters 52 der zweiten Zündstufe AG2 ist ein in Figur 2 symbolisch dargestellter pnp-Transistor T2 angeordnet, der aus einem Abschnitt des p-dotierten Emitters 8, einem Abschnitt der n-dotierten Basis 7 und einem ersten Abschnitt 61 der p-dotierten Basis 6 gebildet ist. In dem ersten Abschnitt 61 der p-dotierten Basis 6 ist deren Netto-Dotierstoffkonzentration lokal erhöht, d.h. sie ist höher als die Netto-Dotierstoffkonzentration der p-dotierten Basis 6 in einem sich in Richtung des Zündauslösebereichs ZAB an den ersten Abschnitt 61 anschließenden vierten Abschnitt 64 der p-dotierten Basis 6, sowie höher als die Netto-Dotierstoffkonzentration der p-dotierten Basis 6 in einem sich in Richtung des n-dotierten Emitters 5 an den Abschnitt 61 anschließenden zweiten Abschnitt 62 der p-dotierten Basis. Die Netto-Dotierstoffkonzentration des zweiten Abschnitts 62 kann dabei größer, gleich oder kleiner sein als die Netto-Dotierstoffkonzentration des vierten Abschnitts 64.

Die lokal erhöhte Netto-Dotierstoffkonzentration des ersten Abschnitts 61 bewirkt einen hohen Verstärkungsfaktor βₚₙₚ des Transistors T2 und damit einhergehend während der Sperrverzögerungszeit eine hohe Konzentration von Ladungsträgerplasma im Bereich der zweiten Zündstufe AG2. Diese im Vergleich zu den Ladungsträgerkonzentrationen in den Bereichen der anderen Zündstufen AG1, AG3 und AG4 hohe Ladungsträgerkonzentration ermöglicht eine gezielte Zündung im Bereich der zweiten Zündstufe AG2, wenn während der Sperrverzögerungszeit ein Spannungspuls in Vorwärtsrichtung auftritt, bei dem der Betrag seiner zeitlichen Ableitung einen kritischen Wert übersteigt.

Allerdings weist der Schichtwiderstand RS der p-dotierten Basis 6 aufgrund der gegenüber den angrenzenden Abschnitten 64 und 62 erhöhten Netto-Dotierstoffkonzentration ein lokales Minimum im Bereich des ersten Abschnitts 61 auf. Als Schichtwiderstand RS, den die p-dotierte Basis 6 an einer bestimmten Koordinate in der lateralen Richtung r aufweist, wird der Quotient aus dem spezifischen Widerstand und der Schichtdicke der p-dotierten Basis 6 an der betrachteten Koordinate verstanden. Die Schichtdicke ist dabei in der vertikalen Richtung v zu ermitteln.

Würde man bei einer herkömmlichen Zündstufe, die so aufgebaut ist wie die Zündstufen AG1, AG3 und AG4, im Bereich des jeweiligen Zündstufenemitters 51, 53 bzw. 54 einen dem Abschnitt 61 entsprechenden Abschnitt mit reduziertem Schichtwiderstand in der p-dotierten Basis 6 vorsehen, ohne weitere Änderungen vorzunehmen, so wäre der zum Zünden der betreffenden Zündstufe AG1, AG3 bzw. AG4 erforderliche Zündstrom höher als ohne einen solchen Abschnitt mit reduziertem Schichtwiderstand. Die Ursache hierfür liegt darin, dass die zum Zünden einer Zündstufe AG1, AG3 bzw. AG4 erforderliche Spannung von etwa 0,7 V bis 0,8 V im wesentlichen durch einen Spannungsabfall an dem Abschnitt der p-dotierten Basis 6 erreicht wird, der sich unterhalb des Zündstufenemitters 51, 53 bzw. 54 und unterhalb der Zündstufenelektrode 41, 43 bzw. 44 der jeweiligen Zündstufe AG1, AG3 bzw. AG4 befindet.

Um den durch den im ersten Abschnitt 61 bewirkte lokale Verringerung des Schichtwiderstandes RS der p-dotierten Basis 6 auszugleichen, ist die Stelle, an der die Zündstufenelektrode 42 der zweiten Zündstufe AG2 an der p-dotierten Basis 6 angeschlossen ist, im Vergleich zum Anschluss der Zündstufenelektroden einer herkömmlichen Zündstufe AG1, AG3 bzw. AG4 in Richtung des n-dotierten Hauptemitters 5 vom Zündstufenemitter 52 beabstandet. Hierdurch wird der unterhalb des Zündstufenemitters 52 und der Zündstufenelektrode 42 befindliche Abschnitt der p-dotierten Basis 6 vergrößert. Damit einhergehend vergrößert sich auch der elektrische Widerstand, der den zum Zünden der zweiten Zündstufe AG2 erforderlichen Spannungsabfall maßgeblich beeinflusst.

Bei dem Thyristor 100 gemäß Figur 2 kontaktiert die Zündstufenelektrode 42 der zweiten Zündstufe AG2 an der Vorderseite 13 den Zündstufenemitter 52 der zweiten Zündstufe AG2 und weist mit diesem eine erste Kontaktfläche 421 auf. Wie dargestellt kann die erste Kontaktfläche 421 ausschließlich den Zündstufenemitter 52, nicht jedoch die p-dotierte Basis 6 kontaktieren, also von dem an der Vorderseite 13 endenden pn-Übergang 521 zwischen dem Zündstufenemitter 52 und der p-dotierten Basis 6 beabstandet sein. Als Kontaktfläche im Sinne der vorliegenden Erfindung wird die gesamte Fläche verstanden, mit der eine Zündstufenelektrode (hier 42) den zugehörigen Zündstufenemitter 52 bzw. die p-dotierte Basis 6 kontaktiert.

Weiterhin kontaktiert die Zündstufenelektrode 42 an einer zweiten Kontaktfläche 422 die p-dotierte Basis 6 auf der dem n-dotierten Emitter 5 zugewandten bzw. dem Zündauslösebereich ZAB (siehe Figur 1) abgewandten Seite des Zündstufenemitters 52 an der Vorderseite 13. Dabei ist die zweite Kontaktfläche 422 sowohl von der ersten Kontaktfläche 421 als auch vom dem Zündstufenemitter 52 beabstandet. In einem Abschnitt zwischen der ersten Kontaktfläche 421 und der zweiten Kontaktfläche 422 ist die Zündstufenelektrode 42 von der Vorderseite 13 beabstandet. Hierzu kann ein optionales Dielektrikum 18 vorgesehen sein, das in der lateralen Richtung r zwischen der ersten Kontaktfläche 421 und der zweiten Kontaktfläche 422 und in der vertikalen Richtung v zwischen der Vorderseite 13 und der Zündstufenelektrode 42 angeordnet und auf die Vorderseite 13 aufgebracht ist. Als Dielektrika 18 eignen sich z.B. Festkörper wie beispielsweise Siliziumoxid oder Siliziumnitrid. Die zweite Kontaktfläche 422 kontaktiert die p-dotierte Basis 6 in einem dritten Abschnitt 63 der p-dotierten Basis 6, in dem die Netto-Dotierstoffkonzentration gegenüber einem fünften Abschnitt 65 der p-dotierten Basis 6, der sich in Richtung des n-dotierten Emitters 5 an den dritten Abschnitt 63 anschließt, erhöht ist. Die erhöhte Dotierung in einem solchen dritten Abschnitt 63 bewirkt eine verbesserte elektrische Anbindung der Zündstufenelektrode 42 an die p-dotierte Basis 6.

Weiterhin kann zur Einstellung des für die Zündempfindlichkeit der zweiten Zündstufe AG2 maßgeblichen Widerstandes des unter dem Zündstufenemitter 52 und der Zündstufenelektrode 42 befindlichen Abschnittes der p-dotierten Basis 6 auch ein optionaler zweiter Abschnitt 62 vorgesehen sein, der in der lateralen Richtung r zwischen dem Zündstufenemitter 52 und der zweiten Kontaktfläche 422 angeordnet ist und in dem der elektrische Widerstand der p-dotierten Basis 6 dadurch lokal erhöht ist, dass die Dicke der p-dotierten Basis 6 lokal reduziert ist und/oder dass die Netto-Dotierstoffkonzentration der p-dotierten Basis 6 lokal reduziert ist.

Bei dem in Figur 2 gezeigten Thyristor 100 ist zum einem die Dicke der p-dotierten Basis 6 im Bereich des zweiten Abschnittes 62 dadurch reduziert, dass sich ein Abschnitt 71 der n-dotierten Basis 7 weiter in Richtung der Vorderseite 13 erstreckt als in den benachbarten Abschnitten der n-dotierten Basis 7. Weiterhin befindet sich der zweite Abschnitt 62 vollständig oder zumindest abschnittweise unterhalb des Abschnitts, in dem die Zündstufenelektrode 42 von der Vorderseite 13 beabstandet ist.

Weiterhin ist die Netto-Dotierstoffkonzentration in dem zweiten Abschnitt 62 gegenüber der Netto-Dotierstoffkonzentration des ersten Abschnitts 61 und optional auch gegenüber der Netto-Dotierstoffkonzentration des vierten Abschnitts 64 reduziert. Außerdem ist die Netto-Dotierstoffkonzentration in dem zweiten Abschnitt 62 gegenüber der Netto-Dotierstoffkonzentration des dritten Abschnitts 63 reduziert. Im Übrigen kann die Netto-Dotierstoffkonzentration in dem zweiten Abschnitt 62 optional auch gegenüber der Netto-Dotierstoffkonzentration des fünften Abschnitts 65 reduziert sein.

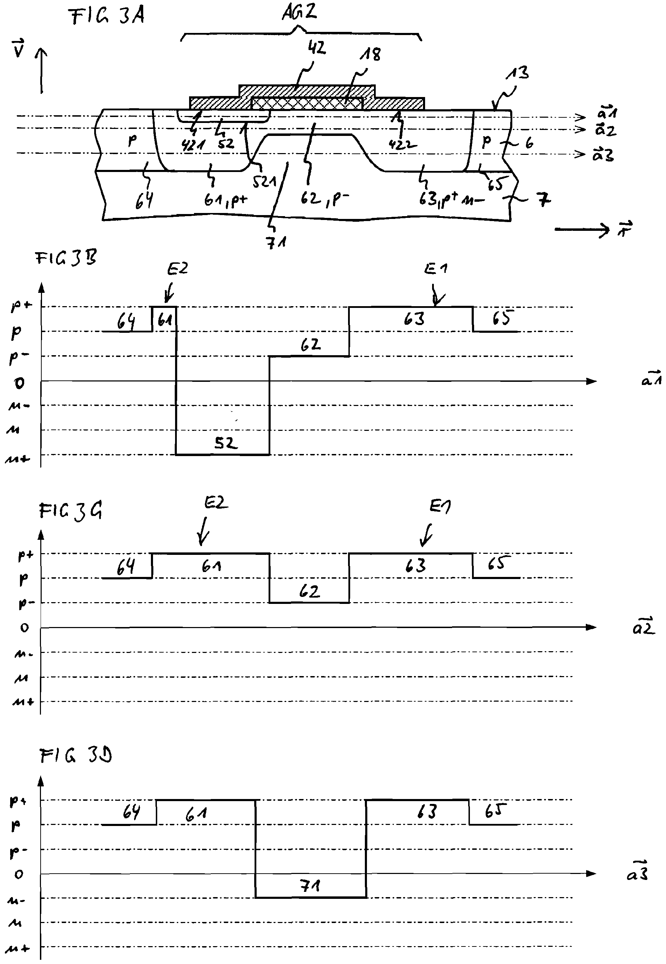

Figur 3A zeigt einen vorderseitigen Abschnitt des in den Figuren 1 und 2 dargestellten Thyristors 100 im Bereich der zweiten Zündstufe AG2. Zusätzlich dargestellt sind drei (virtuelle) Achsen a1, a2 und a3, die jeweils senkrecht zur vertikalen Richtung v durch den Halbleiterkörper verlaufen und die unterschiedlich weit von der Vorderseite 13 beabstandet sind. Die Figuren 3B, 3C und 3D zeigen den Verlauf der Netto-Dotierstoffkonzentration entlang dieser Achsen a1, a2 bzw. a3. An der Ordinate ist in der positiven Richtung die Netto-Dotierstoffkonzentration der p-dotierten Gebiete, in der negativen Richtung die Netto-Dotierstoffkonzentration der n-dotierten Gebiete aufgetragen.

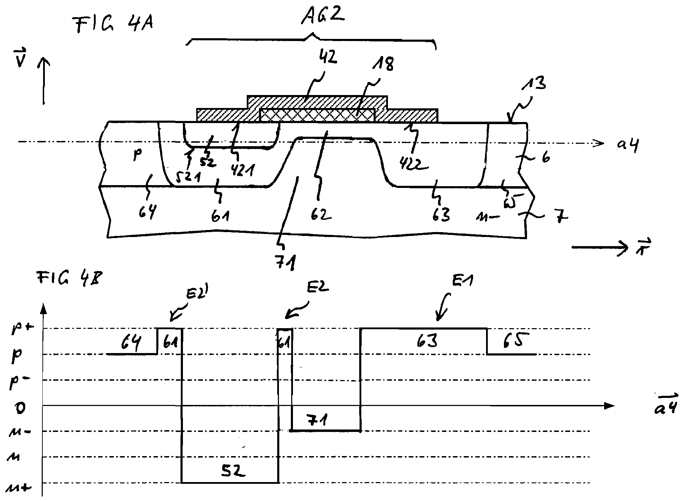

Während bei der Anordnung gemäß Figur 3A die Dicke des zweiten Abschnitts 62 größer ist als die Dicke des Zündstufenemitters 52 der zweiten Zündstufe AG2, ist sie bei der ansonsten identischen Anordnung gemäß Figur 4A kleiner als die Dicke des Zündstufenemitters 52 der zweiten Zündstufe AG2. Figur 4B zeigt den Verlauf der Netto-Dotierstoffkonzentration entlang einer in Figur 4A gezeigten Achsen a4 analog zu den Figuren 3B, 3C und 3D.

Aus den in den Figuren 3B, 3C, 3D und 4B gezeigten Verläufen ist ersichtlich, dass die Netto-Dotierstoffkonzentration zumindest zwei von einander beabstandete Maxima E1, E2 und E2' aufweisen kann, von denen sich zumindest eines (E2, E2') im Bereich des ersten Abschnittes 61 befindet, und ein weiteres (E1) im Bereich des dritten Abschnitts 63.

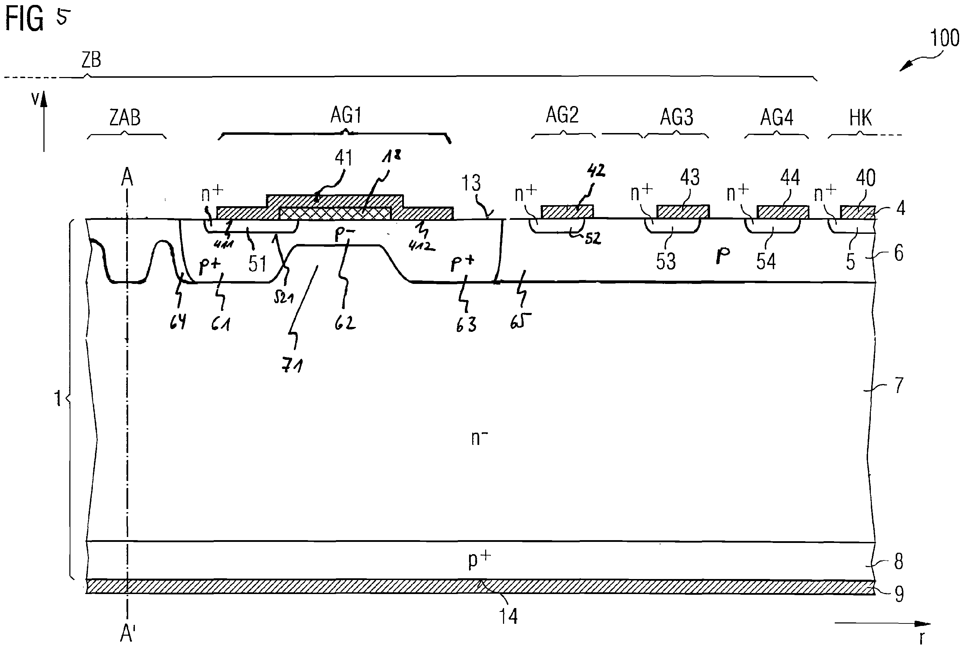

Als Beispiel für einen zu dem Thyristor 100 gemäß den Figuren 1 bis 3A alternativen Thyristor zeigt Figur 5 einen Abschnitt eines Thyristors 100, der ebenfalls vier Zündstufen AG1, AG2, AG3 und AG4 umfasst, bei dem die anhand der Figuren 1 bis 3A erläuterte Ausgestaltung einer Zündstufe nicht wie in diesen Figuren am Beispiel der zweiten Zündstufe AG2 sondern am Beispiel der ersten Zündstufe AG1 realisiert ist. Die Zündstufenelektrode, die erste Kontaktfläche und die zweite Kontaktfläche der ersten Zündstufe AG1 sind entsprechend mit den Bezugszeichen 41, 411 bzw. 412 bezeichnet.

Grundsätzlich kann ein Aufbau, wie er vorangehend in den Figuren 2, 3A und 4A am Beispiel der zweiten Zündstufe AG2 und in Figur 5 anhand der ersten Zündstufe AG1 erläutert wurde, ergänzend oder alternativ auch an einer anderen Zündstufe AG1, AG3, AG4 vorgesehen sein, oder auch an einer beliebigen anderen Zündstufe, falls der Thyristor mehr als vier Zündstufen aufweisen sollte. Weiterhin kann eine solche Ausgestaltung einer Zündstufe an genau einer, mehreren oder allen Zündstufen vorgesehen werden. Im Fall von nur genau einer derart ausgestalteten Zündstufe kann es sich insbesondere um die erste (AG1) oder die zweite (AG2) oder um die dritte (Ag3) oder um die vierte (AG4) Zündstufe des Thyristors 100 handeln, wobei die Zählung bei der dem Zündauslösebereich ZAB (Figur 1) nächstgelegenen Zündstufe AG1 beginnt und in Richtung des n-dotierten Hauptemitters 5 ansteigt. Im Fall von mehreren entsprechend ausgestalteten Zündstufen kann es sich insbesondere um die beiden dem Zündauslösebereich ZAB nächstgelegenen (AG1 und AG2) sämtlicher Zündstufen AG1, AG2, AG3, AG4 des Thyristors 100 handeln.

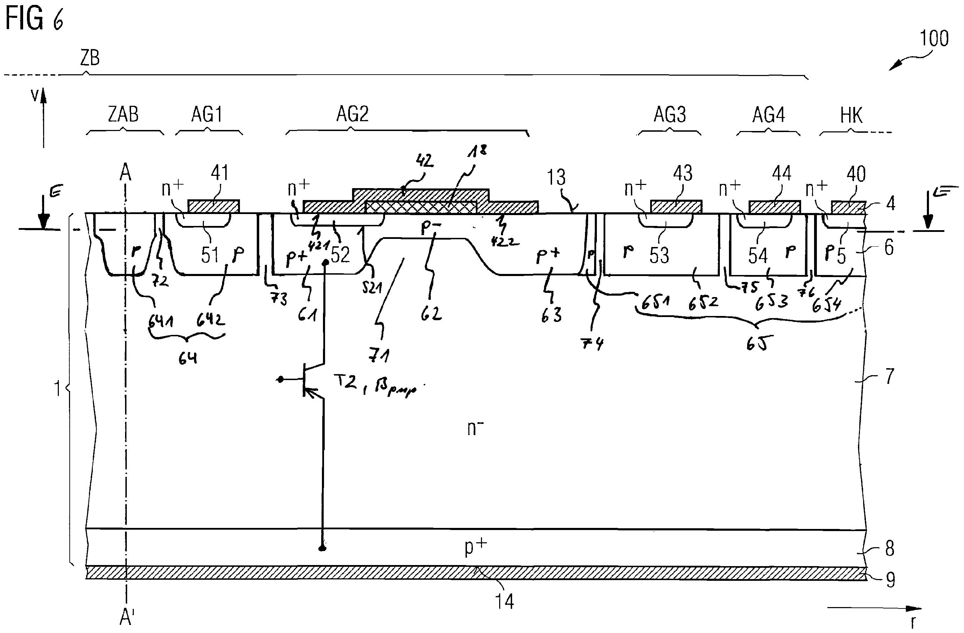

Figur 6 zeigt einen Vertikalschnitt durch einen Thyristor, dessen Aufbau dem Aufbau des Thyristors gemäß Figur 2 entspricht. Darüber hinaus weist der in Figur 6 gezeigte Thyristor mehrere Entkopplungsstrukturen 72, 73, 74, 75, 76 auf, die dazu dienen, Abschnitte der p-dotierten Basis 6 ganz zumindest teilweise elektrisch voneinander zu entkoppeln. Jede der Entkopplungsstrukturen 72, 73, 74, 75, 76 ist durch einen oder mehrere Abschnitte der n-dotierten Basis 7 gebildet, in denen die n-dotierte Basis 7 die p-dotierte Basis 6 durchdringt, und die sich bis zur Vorderseite 13 des Halbleiterkörpers 1 erstrecken.

Mittels einer solchen Entkopplungsstruktur 72, 73, 74, 75, 76 können Abschnitte der p-dotierten Basis 6 elektrisch entkoppelt werden. So führt die Entkopplungsstruktur 72 zu einer Entkopplung zweier Abschnitte 641 und 642 der p-dotierten Basis 6, die zusammen den Abschnitt 64 bilden. Die Entkopplungsstruktur 73 entkoppelt die Abschnitte 64 und 61. Die Entkopplungsstrukturen 74, 75 und 76 entkoppeln jeweils benachbarte 651/652, 652/653, 653/654 der Abschnitte 651, 652, 653 und 654 des Abschnitts 65 der p-dotierten Basis 6.

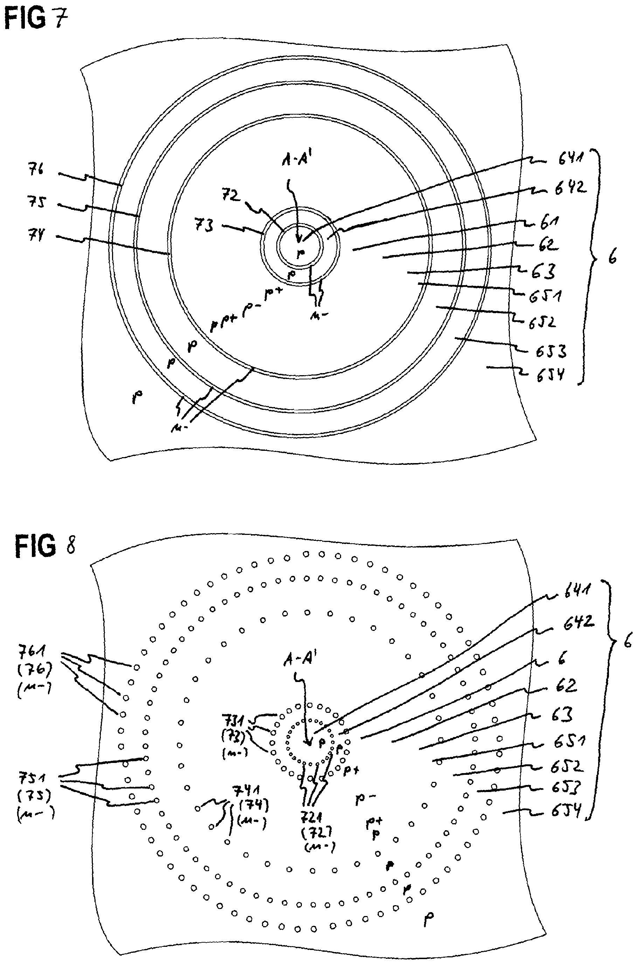

Hierbei kann jede der Entkopplungsstrukturen 72, 73, 74, 75, 76 unabhängig von der Ausgestaltung einer der anderen Entkopplungsstrukturen 72, 73, 74, 75, 76 als geschlossener Ring ausgebildet sein, der um die zentrale Achse A-A' verläuft, und durch den die an ihn angrenzenden Abschnitte der p-dotierten Basis 6, die er entkoppelt, voneinander beabstandet sind. Figur 7 zeigt hierzu beispielhaft einen Horizontalschnitt in einer zur vertikalen Richtung v senkrechten Schnittebene E.

Weiterhin kann jede der in Figur 6 gezeigten Entkopplungsstrukturen 72, 73, 74, 75, 76 unabhängig von der Ausgestaltung einer der anderen Entkopplungsstrukturen 72, 73, 74, 75, 76 eine Vielzahl säulenförmiger Fortsätze der n-dotierten Basis 7 umfassen, von denen sich jeder durchgehend bis zur Vorderseite 13 des Halbleiterkörpers 1 erstreckt, und die entlang eines geschlossenen Rings verlaufen und zu diesem koaxialen Zylindermantel beabstandet voneinander angeordnet sind. Bei einem solchen geschlossenen Ring kann es sich beispielsweise um einen zu der zentralen Achse A-A' koaxialen Zylinderring handeln. Der geschlossene Ring kann beispielsweise um den Zündauslösebereich ZAB herum verlaufen. Figur 8 zeigt hierzu beispielhaft einen Horizontalschnitt in einer zur vertikalen Richtung v senkrechten Schnittebene E. So umfassen die Entkopplungsstruktur 72 eine Vielzahl äquidistant voneinander beabstandeter Fortsätze 721, die Entkopplungsstruktur 73 eine Vielzahl äquidistant voneinander beabstandeter Fortsätze 731, die Entkopplungsstruktur 74 eine Vielzahl äquidistant voneinander beabstandeter Fortsätze 741, die Entkopplungsstruktur 75 eine Vielzahl äquidistant voneinander beabstandeter Fortsätze 751, die Entkopplungsstruktur 76 eine Vielzahl äquidistant voneinander beabstandeter Fortsätze 761. Die Fortsätze 721, 731, 741, 751 und 761 sind jeweils Bestandteil der n-dotierten Basis 7 und stellen jeweils eine durchgehende Verbindung zwischen der n-dotierten Basis 7 und der Vorderseite 13 des Halbleiterkörpers 1 her.

Bei den gemäß Figur 8 ausgebildeten Entkopplungsstrukturen 72, 73, 74, 75, 76 sind die entkoppelten Abschnitte der p-dotierten Basis 6 noch durch verbleibende Abschnitte der p-dotierten Basis 6 miteinander verbunden. Daher ist in diesem Fall die Entkopplung weniger stark ausgeprägt als bei einer als geschlossener Ring ausgebildeten Entkopplungsstrukturen 72, 73, 74, 75, 76, wie sie in Figur 7 gezeigt sind.

Grundsätzlich können als geschlossene Ringe ausgebildete Entkopplungsstrukturen 72, 73, 74, 75, 76, wie sie in Figur 7 gezeigt sind und aus einer Vielzahl säulenartiger Fortsätze 721, 731, 741, 751, 761 gebildeter Entkopplungsstrukturen 72, 73, 74, 75 bzw. 76, wie sie in Figur 8 gezeigt sind, innerhalb eines Thyristor auch in beliebigen Kombinationen miteinander eingesetzt werden.

Generell kann jede der Entkopplungsstrukturen 72, 73, 74, 75, 76 von den n-dotierten Emittern 51, 52, 53, 54 sämtlicher Zündstufen AG1, AG2, AG3, AG4 des Thyristors 100 sowie vom n-dotierten Emitter 5 beabstandet sein. Abgesehen davon kann sich eine Entkopplungsstruktur 72, 73, 74, 75, 76 an einer beliebigen Stelle des Zündbereichs ZB befinden. Eine Entkopplungsstruktur 72, 73, 74, 75, 76 kann beispielsweise an folgenden Stellen vorgesehen sein:

Auf der dem n-dotierten Emitter 5 abgewandten Seite der innersten (AG1) aller Zündstufen AG1, AG2, AG3, AG4 des Thyristors 100 wie die Entkopplungsstruktur 72.

Zwischen der der ersten Kontaktfläche 421 auf deren dem n-dotierten Emitter 5 abgewandten Seite nächstgelegenen (AG1) aller Zündstufen AG1, AG2, AG3, AG4 des Thyristors 100 und der ersten Kontaktfläche 421 wie die Entkopplungsstruktur 73.

Zwischen der zweiten Kontaktfläche 422 und der dieser in Richtung des n-dotierten Emitters 5 nächstgelegenen (AG3) aller Zündstufen AG1, AG2, AG3, AG4 wie die Entkopplungsstruktur 74.

Zwischen zwei benachbarten Zündstufen AG1/AG2, AG2/AG3, AG3/AG4 wie die Entkopplungsstruktur 75.

Zwischen dem n-dotierten Emitter 5 und der dem n-dotierten Emitter 5 nächstgelegenen (AG4) aller Zündstufen AG1, AG2, AG3, AG4 des Thyristors 100 wie die Entkopplungsstruktur 76.

## Patentansprüche

1. Thyristor mit einem Halbleiterkörper (1), in dem in einer vertikalen Richtung (v) ausgehend von einer Rückseite (14) hin zu einer der Rückseite (14) gegenüber liegenden Vorderseite (13) ein p-dotierter Emitter (8), eine n-dotierte Basis (7), eine p-dotierte Basis (6) und ein n-dotierter Emitter (5) aufeinanderfolgend angeordnet sind, und der folgende Merkmale aufweist:
- eine Zündstufenstruktur (AG) mit wenigstens einer Zündstufe (AG1, AG2, AG3 , AG4), von denen jede einen vom n-dotierten Emitter (5) beabstandeten, n-dotierten Zündstufenemitter (51, 52, 53, 54) umfasst, der in die p-dotierte Basis (6) eingebettet ist;
- eine Elektrode (42), die an der Vorderseite (13) einen (52) der Zündstufenemitter (51, 52, 53, 54) kontaktiert und mit diesem eine erste Kontaktfläche (421) aufweist, und die die p-dotierte Basis (6) auf der dem n-dotierten Emitter (5) zugewandten Seite des einen (52) der Zündstufenemitter an der Vorderseite (13) an einer zweiten Kontaktfläche (422) kontaktiert, wobei die p-dotierte Basis (6) einen Abschnitt (60) mit einem ersten Teilabschnitt (61), einem zweiten Teilabschnitt (62) und einem dritten Teilabschnitt (63) aufweist, wobei
- der erste Teilabschnitt (61) und der dritte Teilabschnitt (63) eine höhere Netto-Dotierstoffkonzentration (p+) aufweisen als der zweite Teilabschnitt (62);
- der zweite Teilabschnitt (62) an den ersten Teilabschnitt (61) und an den dritten Teilabschnitt (63) angrenzt; und
- zwischen dem einen (52) der Zündstufenemitter (51, 52, 53, 54) und dem ersten Teilabschnitt (61) ein pn-Übergang (521) ausgebildet ist, wobei die Netto-Dotierstoffkonzentration entlang einer zur vertikalen Richtung (v) senkrechten Achse (a1, a2 , a3 , a4) wenigstens zwei voneinander beabstandete, lokale Maxima (E1, E2 , E2) aufweist, an denen der Leitungstyp "p" vorliegt, von denen sich zumindest eines (E2 , E2') im Bereich des ersten Abschnitts (61) und ein weiteres (E1) im Bereich des dritten Abschnitts (63) befindet,
und
wobei entlang der zur vertikalen Richtung (v) senkrechten Achse (a3, a4) zwischen wenigstens zwei voreinander beabstandeten, lokalen Maxima (E1, E2) ein Abschnitt (71) der n-dotierten Basis (7) angeordnet ist und
wobei
die erste Kontaktfläche (421) ausschließlich den Zündstufenemitter (52) kontaktiert, die zweite Kontaktfläche (422) sowohl von der ersten Kontaktfläche (421) als auch vom dem einen (52) der Zündstufenemitter beabstandet ist, der eine (52) der Zündstufenemitter (51, 52, 53, 54) in den ersten Teilabschnitt (61) eingebettet ist und die zweite Kontaktfläche (422) den dritten Teilabschnitt (63) kontaktiert.

2. Thyristor nach Anspruch 1, bei dem ein Dielektrikum (18) zwischen der ersten Kontaktfläche (421) und der zweiten Kontaktfläche (422) auf die Vorderseite (13) aufgebracht ist.

3. Thyristor nach Anspruch 2, bei dem das Dielektrikum (18) zumindest abschnittweise zwischen der Elektrode (42) und der Vorderseite (13) angeordnet ist.

4. Thyristor nach einem der Ansprüche 2 oder 3, bei dem die p-dotierte Basis (6) einen Schichtwiderstand (RS) mit einem lokalen Maximum aufweist.

5. Thyristor nach Anspruch 4, bei dem sich das lokale Maximum zwischen der ersten Kontaktfläche (421) und der n-dotierten Basis (7) befindet.

6. Thyristor nach Anspruch 4, bei dem sich das lokale Maximum zwischen dem Dielektrikum (18) und der n-dotierten Basis (7) befindet.

7. Thyristor nach einem der vorangehenden Ansprüche, bei dem sich eines der lokalen Maxima (E1) zwischen der zweiten Kontaktfläche (422) und der n-dotierten Basis (7) befindet.

8. Thyristor nach einem der vorangehenden Ansprüche, bei dem die erste Kontaktfläche (421) von der p-dotierten Basis (6) beabstandet ist.

9. Thyristor nach einem der vorangehenden Ansprüche, bei dem die erste Kontaktfläche (421) und die zweite Kontaktfläche (422) durch einen Abschnitt der Vorderseite (13) voneinander beabstandet sind, der als geschlossener Ring ausgebildet ist, und den die Elektrode (42) an keiner Stelle kontaktiert.

10. Thyristor nach einem der vorangehenden Ansprüche, der einen Zündauslösebereich (ZAB) aufweist, bei dem die Zündstufenstruktur (AG) zwischen dem Zündauslösebereich (ZAB) und dem n-dotierten Emitter (5) angeordnet ist.

11. Thyristor nach Anspruch 10, bei dem die eine der Zündstufen (AG1) die dem Zündauslösebereich (ZAB) nächstgelegene Zündstufe ist.

12. Thyristor nach Anspruch 10, bei dem die eine der Zündstufen (AG2) die Zündstufe ist, die der dem Zündauslösebereich (ZAB) nächstgelegenen Zündstufe (AG1) am nächsten liegt.

## Claims

1. A thyristor having a semiconductor body (1), wherein, in the vertical direction (v), from the back face (14) to the front face (13) situated opposite to the back face (14), a n-doped emitter (8), a n-doped base (7), a p-doped base (6) and a n-doped emitter (5) are successively arranged, and which comprises the following features:
- an ignition stage structure (AG) with at least one ignition stage (AG1, AG2, AG3, AG4), each of which comprises an n-doped ignition stage emitter (51, 52, 53, 54) spaced apart from the n-doped emitter, which is embedded in the p-doped base (6);
- an electrode (42), which, on the front face (13), contacts one (52) of the ignition stage emitters (51, 52, 53, 54) and, with said one shares a first contact surface (421), and which contacts the p-doped base (6) at a face (52) of the ignition stage emitters facing the n-doped emitter on the front face (13) on a second contact surface (422), wherein the p-doped base (6) comprises a portion (60) having a first sub-portion (61), a second sub-portion (62) and a third sub-portion (63), wherein
- the first sub-portion (61) and the third sub-portion (63) have a net concentration of doping substance (p+) larger than the second sub-portion (62) ;
- the second sub-portion (62) is adjacent to the first sub-portion (61) and the third sub-portion (63); and
- a P-N junction (521) is formed between one (52) of the ignition stage emitters (51, 52, 53, 54) and the first sub-portion (61),
wherein the net concentration of doping substance has at least two local maxima (E1, E2, E2) spaced apart from each other along an axis (a1, a2 , a3, a4) perpendicular to the vertical direction (v), wherein in said local maxima the p-type conductor is present, at least one (E2, E2') of which is in the region of the first sub-portion (61) and another one (E1) is in the region of the third sub-portion (63), and
wherein a portion (71) of the n-doped base (7) is arranged along the axis (a3, a4) perpendicular to the vertical direction (v), between at least two local maxima (E1, E2) spaced apart from each other, and
wherein
the first contact surface (421) exclusively contacts the ignition stage emitter (52), the second contact surface (422) is both spaced apart from the first contact surface (421) and one (52) of the ignition stage emitters, such that one (52) of the ignition stage emitters (51, 52, 53, 54) is embedded into the first sub-portion (61), and the second contact surface (422) contacts the third sub-portion (63).

2. The thyristor according to claim 1, wherein a dielectric (18) is applied onto the front face (13) between the first contact surface (421) and the second contact surface (422).

3. The thyristor according to claim 2, wherein the dielectric (18) is arranged at least sectionally between the electrode (42) and the front face (13).

4. The thyristor according to one of the claims 2 or 3, wherein the p-doped base (6) has a layer resistance (RS) having a local maximum.

5. The thyristor according to claim 4, wherein the local maximum is between the first contact surface and the n-doped base (7).

6. The thyristor according to claim 4, wherein the local maximum is between the dielectric (18) and the n-doped base (7).

7. The thyristor according to one of the preceding claims, wherein one of the local maxima (E1) is between the second contact surface (422) and the n-doped base (7).

8. The thyristor according to one of the preceding claims, wherein the first contact surface (421) is spaced apart from the p-doped base (6).

9. The thyristor according to one of the preceding claims, wherein the first contact surface (421) and the second contact surface (422) are spaced apart from each other by a portion of the front face (13), which is formed as a closed ring, and which is not contacted by the electrode (42) at any point.

10. The thyristor according to one of the preceding claims, which has an ignition trigger region (ZAB), wherein the ignition stage structure (AG) is arranged between the ignition trigger region (ZAB) and the n-doped emitter (5).

11. The thyristor according to claim 10, wherein one (AG1) of the ignition stages is the ignition stage closest to the ignition trigger region (ZAB).

12. The thyristor according to claim 10, wherein one (AG2) of the ignition stages (AG2) is the ignition stage proximal to the ignition stage (AG1) proximal to the ignition trigger region (ZAB).

## Revendications

1. Thyristor ayant un corps semi-conducteur (1), dans lequel, en direction verticale (v), à partir d'une face arrière (14) vers l'avant (13) situé opposé de la face arrière (14), un émetteur dopé n (8), une base (7) dopée n, une base (6) dopée p et un émetteur (5) dopé n sont arrangés successivement, et qui comprend les caractéristiques suivantes :
- une structure de l'étape d'allumage (AG) avec au moins une étape d'allumage (AG1, AG2, AG3, AG4), dont lesquelles chacune comprend un émetteur de l'étape d'allumage (51, 52, 53, 54) dopé n espacé de l'émetteur (5) dopé n, qui est incorporé dans la base (6) dopée p ;
- une électrode (42), qui, à la face avant (13), est mise en contact avec l'un (52) des émetteurs de l'étape d'allumage (51, 52, 53, 54) et, avec celui-ci, partage une première surface de contact (421), et qui est mise en contact avec la base (6) dopée psur la face de l'un (52) des émetteurs de l'étape d'allumage orientée vers l'émetteur dopé n à la face avant (13) à une deuxième surface de contact (422), dans lequel la base (6) dopée pcomprend une partie (60) ayant un premier tronçon (61), un deuxième tronçon (62) et un troisième tronçon (63), dans lequel
- le premier tronçon (61) et le troisième tronçon (63) ont une concentration nette en matière dopant (p+) supérieure au deuxième tronçon (62) ;
- le deuxième tronçon (62) est adjacent au premier tronçon (61) et au troisième tronçon (63) ; et
- une jonction P-N (521) est formée entre l'un (52) des émetteurs de l'étape d'allumage (51, 52, 53, 54) et le premier tronçon (61),
dans lequel la concentration nette en matière dopant a au moins deux maxima (E1, E2, E2) locales espacés l'un de l'autre le long une axe perpendiculaire (a1, a2 , a3 , a4) à la direction verticale (v), chez lesquels le type conducteur « P » est présent, dont lesquels au moins l'un (E2 , E2') est dans la région du premier tronçon (61) et un autre (E1) est dans la région du troisième tronçon (63), et
dans lequel une partie (71) de la base dopée n (7) est arrangée, le long de l'axe (a3, a4) perpendiculaire à la direction verticale (v), entre au moins deux maximaux locales (E1, E2) espacés l'un de l'autre, et
dans lequel
la première surface de contact (421) est mise en contact exclusivement avec l'émetteur de l'étape d'allumage (52), la deuxième surface de contact (422) est espacée de la première surface de contact (421) aussi bien que de l'un (52) des émetteurs de l'étape d'allumage, de façon que l'un (52) des émetteurs de l'étape d'allumage (51, 52, 53, 54) est incorporé dans le premier tronçon (61) et la deuxième surface de contact (422) est mise en contact avec le troisième tronçon (63).

2. Thyristor selon la revendication 1, dans lequel un diélectrique (18) est appliqué sur l'avant (13) entre la première surface de contact (421) et la deuxième surface de contact (422).

3. Thyristor selon la revendication 2, dans lequel le diélectrique (18) est arrangé au moins par passages entre l'électrode (42) et l'avant (13).

4. Thyristor selon l'une des revendications 2 ou 3, dans lequel la base (6) dopée p a une résistance à couche (RS) ayant un maximum local.

5. Thyristor selon la revendication 4, dans lequel le maximum local est entre le premier surface de contact et la base (7) dopée n.

6. Thyristor selon la revendication 4, dans lequel le maximum local est entre le diélectrique (18) et la base (7) dopée n.

7. Thyristor selon l'une des revendications précédentes, dans lequel'un des maximaux locales (EI) est entre la deuxième surface de contact (422) et la base (7) dopée n.

8. Thyristor selon l'une des revendications précédentes, dans lequel la première surface de contact (421) est espacée de la base (6) dopée p.

9. Thyristor selon l'une des revendications précédentes, dans lequel la première surface de contact (421) et la deuxième surface de contact (422) sont espacées l'une de l'autre par une partie de la face avant (13), qui est formée comme une cycle fermé, et avec lequel l'électrode (42) n'est mise en contact à aucun endroit.

10. Thyristor selon l'une des revendications précédentes, qui a une région de déclenchement d'allumage (ZAB), dans lequel la structure de l'étape d'allumage (AG) est arrangée entre la région de déclenchement d'allumage (ZAB) et l'émetteur dopé n (5).

11. Thyristor selon la revendication 10, dans lequel l'une des étapes d'allumage (AG1) est l'étape d'allumage la plus proche à la région de déclenchement l'allumage (ZAB).

12. Thyristor selon la revendication 10, dans lequel l'une des étapes d'allumage (AG2) est l'étape d'allumage, qui est proximale à l'étape d'allumage (AG1) proximale à la région de déclenchement l'allumage (ZAB).
